# EUROPÄISCHE PATENTANMELDUNG

(11) **EP 1 310 979 A2**
(43) Veröffentlichungstag der Anmeldung: **14.05.2003**
(21) Anmeldenummer: 02022826.8
(22) Anmeldetag: 12.10.2002
(51) Int. Cl.: H01J 37/32

(54) **Einrichtung fuer die Regelung einer Plasmaimpedanz**

(30) Priorität: 07.11.2001 DE 10154229
(71) Anmelder: Applied Films GmbH & Co. KG, 63755 Alzenau (DE)
(72) Erfinder: Willms, Thomas, Dipl.-Phys. Dipl.-Ing., 44575 Castrop-Rauxel (DE); Bruch, Jürgen, Dipl.-Ing., 61130 Nidderau (DE)
(74) Vertreter: Schickedanz, Willi, Dr. Dipl.-Ing.

(57) **Zusammenfassung**

Die Erfindung betrifft eine Einrichtung zum Regeln einer Plasmaimpedanz in einer Vakuumkammer, wobei wenigstens eine Elektrode mit einem Wechselstromgenerator in Verbindung steht. Dieser Wechselstromgenerator ist ein Freischwinger, dessen Frequenz sich auf die Resonanzfrequenz der von ihm beaufschlagten Last einstellt. Diese Last besteht aus festen Schaltelementen und aus einer variablen Plasmaimpedanz. Ändert sich die Plasmaimpedanz, ändert sich mit ihr auch die Resonanzfrequenz. Die Plasmaimpedanz kann somit durch Erfassung der Resonanzfrequenz und durch Vorgabe eines Frequenz-Sollwerts verändert werden, z. B. indem die Spannung, der Strom, die Leistung oder der Gaszufluss in Abhängigkeit von der Differenz zwischen Resonanzfrequenz und Frequenz-Sollwert verändert wird.

## Beschreibung

Die Erfindung betrifft eine Einrichtung für die Regelung einer Plasmaimpedanz nach dem Oberbegriff des Patentanspruchs 1.

Zum Ätzen und Bedampfen von Substraten wird sehr oft die so genannte Sputtertechnik eingesetzt, bei welcher in einer Vakuumkammer bei niedrigem Druck die Ionen eines Gases auf Elektroden beschleunigt werden, wo sie Partikel herausschlagen, die dann ein Substrat beschichten oder ätzen. Die Beschleunigung der Gas-Ionen erfolgt entweder mittels einer Gleich- oder einer Wechselspannung, die am Substrat und an den Elektroden liegt.

Wird eine Wechselspannung angelegt, so besteht der gesamte elektrische Kreis in der Regel aus einer Wechselspannungsquelle, einem Netzwerk und einer Plasmaimpedanz, d. h. der Impedanz zwischen den Elektroden bzw. zwischen einer Elektrode und dem Substrat. Während das Netzwerk in der Regel konstante elektrische Bauelemente besitzt, die sich während des Betriebs nicht verändern, kann sich die Plasmaimpedanz dadurch ändern, dass sich der Anteil der Ionen und/oder Elektronen relativ zu den elektrisch neutralen Partikeln verändert.

Will man beim reaktiven Mittelfrequenz-Sputtern eine hohe Sputterrate erzielen, ist es erforderlich, im Übergangsbereich zwischen dem metallischen und dem voll reaktiven Mode zu arbeiten. Dabei soll der Betrieb stabil bleiben. Bei großen Leistungen und/oder Kathodenlängen ist ein stabiler Betrieb im Übergangsbereich allerdings oft schwer erzielbar, weil leicht ein unkontrolliertes Kippen vom metallischen in den voll reaktiven Mode und umgekehrt erfolgt.

Es ist bekannt, dass die Impedanz vor der Zündung des Plasmas annähernd unendlich groß ist und sich nach der Zündung, abhängig vom Arbeitspunkt, auf einen Wert > 0 Ω einstellt. Außerdem ist bekannt, dass das vorbeschriebene System aus Wechselspannungsquelle, Netzwerk und Plasmaimpedanz einen Resonanzkreis darstellt, dessen Resonanzfrequenz sich mit der Plasmaimpedanz ändert (Society of Vacuum Coaters, Konferenzbeitrag Hüttinger Elektronik, 1999). Mittel, mit denen ein stabiler Sputterbetrieb erzielt werden kann, sind in dieser Veröffentlichung nicht angegeben. Vielmehr ist lediglich der Zustand beschrieben, der sich im ungeregelten Zustand bei Vorgabe der Prozessparameter Leistung und Gasflüsse einstellt. Dieser Zustand definiert einen bestimmten Arbeitspunkt bei einer bestimmten Plasmaimpedanz und damit eine bestimmte Resonanzfrequenz.

Weiterhin ist eine Einrichtung zum Regeln einer Sputteranlage bekannt, bei welcher die elektrische Impedanz des Plasmas durch Regeln der Stärke des magnetischen Feldes erfolgt (DE 34 25 659 A1). Die Speisung der Kathode erfolgt hierbei allerdings mit Gleichspannung.

Bei einem anderen bekannten Verfahren zum Beschichten eines Substrats mittels einer Sputtervorrichtung soll der Arbeitspunkt schnell und einfach stabilisiert werden (EP 0 795 890 A2). Hierbei pendelt die der Zerstäubungselektrode zugeführte elektrische Leistung zwischen zwei Werten. Die Leistungswerte werden dabei so ausgewählt, dass sich bei gleichem Reaktivgaszufluss das Target der Zerstäubungselektrode beim ersten Leistungswert im metallischen Mode befindet, während es sich beim zweiten Leistungswert im oxidischen Mode befindet. Eine Regelung der Plasmaimpedanz findet bei diesem Verfahren nicht statt.

Eine Stabilisierung eines Mittelfrequenz-Sputterprozesses ohne externe Regelung, bei welcher die Netzwerkanpassung so gewählt ist, dass den Störungen entgegengewirkt wird, ist ebenfalls bekannt (DE 195 37 212 A1 = US-PS 5 807 470).

Es sind außerdem ein Verfahren und eine Anlage zur Beschichtung mindestens eines Gegenstands mit mindestens einer Schicht bekannt, wobei ein ohmisch leitendes Target in einer mittels Gleichstrom und diesem überlagertem Wechselstrom betriebenen Glimmentladung zerstäubt wird (EP 0 508 359 A1). Der Beschichtungsprozess wird dabei im instabilen Übergangsmode zwischen metallischem und reaktivem Mode betrieben. Durch Regelung wird dieser Prozess im instabilen Übergangsmode stabil siert, und zwar im Übergangsmode in der Nähe zum Übergang in den metallischen Mode. Als Stellgrößen werden im Regelkreis das Gleichstromsignal und/oder die Frequenz des Gleichstromsignals und/oder die Frequenz und/oder die Amplitude des Wechselstromsignals eingesetzt. Die Istwert-Erfassung erfolgt durch ein optisches Verfahren, insbesondere durch Absorptions- und/oder Fluoreszenzspektroskopie. Eine derartige Istwert-Erfassung ist relativ aufwändig.

Bei einem anderen bekannten Verfahren zum reaktiven Beschichten eines Substrats wird die Frequenz der Wechselstromquelle während des Sputterprozesses so eingestellt, dass die Ionen dem Wechselfeld noch folgen können, was bei einer Frequenz von etwa 1 kHz bis 100 kHz der Fall ist (DE 41 06 770 A1). Eine abgegriffene Entladespannung wird mit Hilfe einer Spannungseffektivwerterfassung als Gleichspannung einem Regler zugeführt, der wiederum ein Magnetventil für die Zuführung eines Reaktivgases ansteuert, und zwar derart, dass die gemessene Spannung die erforderliche Reaktivgasmenge bestimmt. Es wird also bei konstanter Wechselstromfrequenz eine Spannung gemessen, die ihrerseits die Reaktivgasmessung festlegt.

Weiterhin ist eine Balanceregelung für reaktives Magnetronsputtern zur optischen Großflächenbeschichtung bekannt, bei welcher die Instabilität des Übergangsbereichs zwischen dem metallischen Arbeitsbereich und dem oxidischen Arbeitsbereich durch eine Regelung verringert oder beseitigt wird (C. May und J. Strümpfel: Balanceregelung für reaktives Magnetronsputtern zur optischen Großflächenbeschichtung, Vakuum in Forschung und Praxis, 2001, Nr. 2, S. 79 bis 84). Hierbei werden für die Istwert-Erfassung die optische Spektroskopie, die Partialdruckmessung und die Plasmaimpedanz herangezogen. Die Regelung der Plasmaimpedanz erfolgt über die Entladespannung, die zur Beibehaltung der von einer Mittelfrequenz-Stromversorgung konstant gehaltenen Leistung erforderlich ist. Eine Frequenzveränderung der Spannung findet indessen nicht statt.

Schließlich ist auch noch ein Hochleistungsgenerator für das Mittelfrequenz-Sputtern mit Doppelmagnetron bekannt, der eine hohe Leistungsstabilität und eine Anpassung an verschiedene Lastimpedanzen gewährleistet (T. Rettich, P. Wiedemuth: High power generators for medium frequency sputtering applications, Journal of Non-Crystalline Solids 218, 1997, S. 50 bis 53). Dieser Oszillator weist einen Resonanzkreis auf und kann Spannungen von 300 V bis zu mehr als 1200 V bereitstellen. Sein Frequenzbereich geht von 20 bis 100 kHz. In Abhängigkeit von dem zu sputternden Material wird die jeweils optimale Frequenz eingestellt. Entsprechend einer besonderen Auslegung des frei schwingenden Oszillators erfolgt die Reaktion auf Lastschwankungen innerhalb einer Halbwelle. Laständerungen resultieren sofort in Frequenzänderungen, wodurch eine Fehlanpassung vermieden wird. Diese Frequenzänderung wird jedoch nicht als Messgröße zur Istwert-Erfassung der zu regelnden Systemimpedanz genutzt.

Der Erfindung liegt die Aufgabe zugrunde, eine Regeleinrichtung zu schaffen, mit der die Prozessbedingungen konstant gehalten werden können.

Diese Aufgabe wird gemäß den Merkmalen des Patentanspruchs 1 gelöst.

Die Erfindung betrifft somit eine Einrichtung zum Regeln einer Plasmaimpedanz in einer Vakuumkammer, wobei wenigstens eine Elektrode mit einem Wechselstromgenerator in Verbindung steht. Dieser Wechselstromgenerator ist ein Freischwinger, dessen Frequenz sich auf die Resonanzfrequenz der von ihm beaufschlagten Last einstellt. Diese Last besteht aus festen Schaltelementen und aus einer variablen Plasmaimpedanz. Ändert sich die Plasmaimpedanz, ändert sich mit ihr auch die Resonanzfrequenz. Die Plasmaimpedanz kann somit durch Erfassung der Resonanzfrequenz und durch Vorgabe eines Frequenz-Sollwerts verändert werden, z. B. indem die Spannung, der Strom, die Leistung oder der Gaszufluss in Abhängigkeit von der Differenz zwischen Resonanzfrequenz und Frequenz-Sollwert verändert wird.

Ein mit der Erfindung erzielter Vorteil besteht darin, dass die Regelung ohne einen Sensor, z. B. einen optischen Sensor, eine λ-Sonde oder ein Massenspektrometer, auskommt, mit dem der Plasmazustand festgestellt wird. Ein weiterer Vorteil besteht darin, dass Si₃N₄-Prozesse geregelt werden können. Außerdem wird der Arbeitspunkt des Plasmaprozesses exakt eingehalten.

Ausführungsbeispiele der Erfindung sind in den Zeichnungen dargestellt und werden im Folgenden näher beschrieben. Es zeigen:
- Fig. 1: eine erste Ausführungsform der Erfindung, bei welcher die Impedanz durch Steuerung des Zuflusses von Prozess- und/oder Reaktivgas geregelt wird;
- Fig. 2: eine Kennliniendarstellung, die den Zusammenhang zwischen Plasmaimpedanz und Resonanzfrequenz zeigt;
- Fig. 3: eine zweite Ausführungsform der Erfindung, bei welcher die Impedanz durch Steuerung der Spannung, des Stroms und/oder der Leistung geregelt werden.

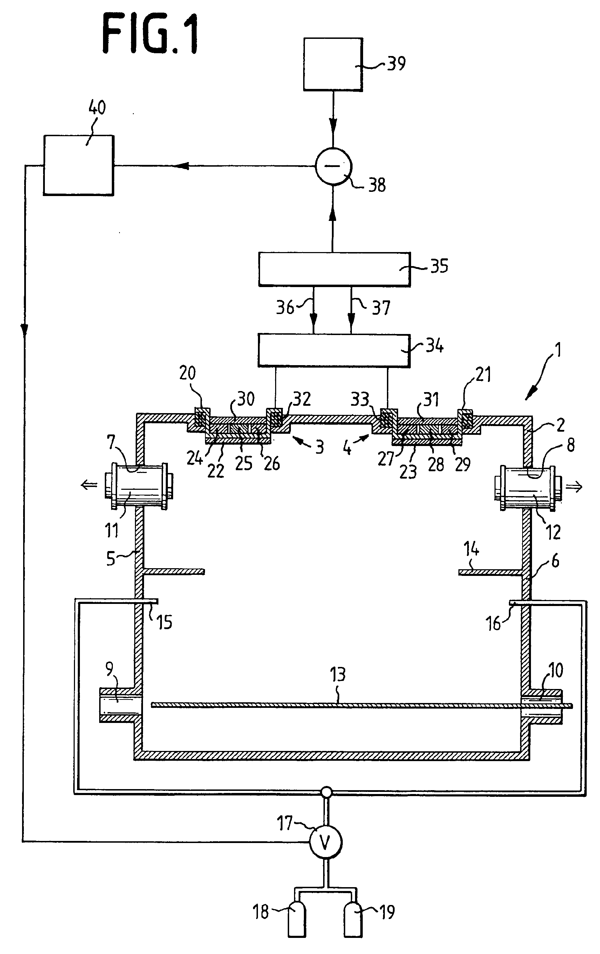

In der Fig. 1 ist eine Sputteranlage 1 dargestellt, die eine Vakuumkammer 2 aufweist, in der sich zwei Magnetrons 3, 4 befinden. In Seitenwänden 5, 6 der Vakuumkammer 2 sind obere Öffnungen 7, 8 und untere Öffnungen 9, 10 vorgesehen, wobei sich in den oberen Öffnungen 7, 8 Vakuumpumpen 11, 12 befinden, während die unteren Öffnungen 9, 10 zur Durchschleusung eines Substrats 13, beispielsweise einer Glasplatte, durch die Vakuumkammer 2 dienen. Zwischen den unteren Öffnungen 9, 10 und den oberen Öffnungen 7, 8 befindet sich eine Blende 14, die von den Seitenwänden 5, 6 in das Innere der Vakuumkammer 2 ragt. Unterhalb dieser Blende 14 befinden sich Gaszuführungen 15, 16, die über ein Ventil 17 mit Gasbehältern 18, 19 in Verbindung stehen.

Die Magnetrons 3, 4 weisen jeweils eine Kathodenwanne 20, 21 auf, die auf ihrer Unterseite mit einem Target 22, 23 versehen ist. In den Kathodenwannen 20, 21 befinden sich jeweils drei Dauermagnete 24, 25, 26 bzw. 27, 28, 29, die mit einem gemeinsamen Joch 30, 31 verbunden sind.

Die Kathodenwannen 20, 21 sind über Dichtungen 32, 33 in die Oberseite der Vakuumkammer 2 eingepasst. Beide Kathodenwannen 20, 21 sind mit einem elektrischen Filter 34 verbunden, das an einem Mittelfrequenzgenerator 35 liegt. Bei diesem Mittelfrequenzgenerator 35 handelt es sich nicht um einen Festfrequenzoszillator oder durchstimmbaren Oszillator, sondern um einen frei schwingenden Oszillator, dessen Frequenz stets mit der Resonanzfrequenz des mit ihm verbundenen Netzwerks übereinstimmt. Im Einzelnen kann dieser Freischwinger aus einer vier IGBT-Module enthaltenden H-Wechselrichterschaltung bestehen, die auf das Netzwerk und die Plasmaimpedanz arbeitet. Gespeist wird die Wechselrichterschaltung über einen Gleichstromzwischenkreis im Mittelfrequenzgenerator 35. Dieser ist potentialfrei. Eine Steuerelektronik ermittelt über Strom- und Spannungsmessung im Ausgang des Wechselrichters die Resonanzfrequenz des schwingungsfähigen Ausgangs und steuert die IGBT-Module mit dieser an. Die Art der Wechselrichterschaltung sowie das resonante Ansteuern ist bei Mittelfrequenzversorgungen bekannt (Generator der Fa. Hüttinger oder der Fa. EMA-Indutec).

Das Netzwerk setzt sich innerhalb des Mittelfrequenzgenerators 35 aus einem Schwingkreis, einem Ausgangstransformator und außerhalb des Generators aus Zuführungsleitungen 36, 37, der Kapazität und Induktivität des Filters 34 und der Plasmaimpedanz zusammen. Das Netzwerk hat die Eigenschaft, die Stabilität des Prozesses durch Unterdrückung von Stromtransienten zu erhöhen. Weiterhin kann mit dem Netzwerk der Impedanzwert, bei dem Leistungsanpassung vorliegt, variiert werden, was zur Arbeitspunktstabilisierung beitragen kann.

Unter Plasmaimpedanz wird bei dem Ausführungsbeispiel der Fig. 1 der Wechselstromwiderstand des Plasmas zwischen den beiden Magnetrons 3, 4 verstanden. Wäre nur ein Magnetron vorhanden, läge die Plasmaimpedanz zwischen diesem Magnetron und dem Substrat oder einer anderen Stelle, an welche die zweite Polarität des Wechselstroms angeschlossen ist. Da die Gesamtimpedanz, mit welcher der Mittelfrequenzgenerator 35 belastet wird, bis auf die Plasmaimpedanz konstant ist, wird die Resonanzfrequenz und damit die Frequenz, mit welcher der Mittelfrequenzgenerator 35 schwingt, durch die Plasmaimpedanz bestimmt. Die jeweilige Ist-Frequenz des Mittelfrequenzgenerators 35 entspricht somit der Resonanzfrequenz des ganzen Kreises und ist folglich eine Funktion der Plasmaimpedanz. Die Ist-Frequenz wird einem Vergleicher 38 zugeführt, dem auch eine Soll-Frequenz aus einem Soll-Frequenzgeber 39 zugeführt wird. Die Soll-Frequenz entspricht also einer regelungstechnischen Führungsgröße.

Die Differenz zwischen Frequenz-Ist- und -Sollwert wird einem Regler 40 zugeführt, der aus dieser Differenz ein Steuersignal für das Ventil 17 bildet. Bei dem Regler 40 kann es sich um einen PI-, einen PID- oder einen Software-Fuzzy-Regler mit angepasster Regelcharakteristik handeln. Ändert sich die Frequenz des freischwingenden Mittelfrequenzgenerators 35 aufgrund einer Änderung der Plasmaimpedanz, wird durch den Differenzbildner 38 eine Differenz zwischen dem aktuellen Istwert und dem Sollwert aus dem Sollwertgeber gebildet und an den Regler 40 gegeben. Dieser erzeugt hierauf ein Regelsignal, welches der Frequenz-Differenz entgegenwirkt, d. h. der Gaszustrom und damit die Plasmaimpedanz wird derart verändert, dass sich die Soll-Frequenz einstellt.

Der Mittelfrequenzgenerator 35 schwingt grundsätzlich und immer auf der Resonanzfrequenz des Ausgangs aus Schwingkreis, Netzwerk und Plasmaimpedanz. Da alle Elemente in Schwingkreis und Netzwerk fest sind, hängt die Resonanzfrequenz nur von der Plasmaimpedanz ab. Geregelt wird die Plasmaimpedanz und nicht die Frequenz. Die Frequenz stellt lediglich einen indirekten Istwert für die Impedanz dar, d. h. ändert man über die Stellgrößen Leistung, Strom, Spannung und/oder Gasfluss die Impedanz, so ändert sich auch der Istwert der Resonanzfrequenz.

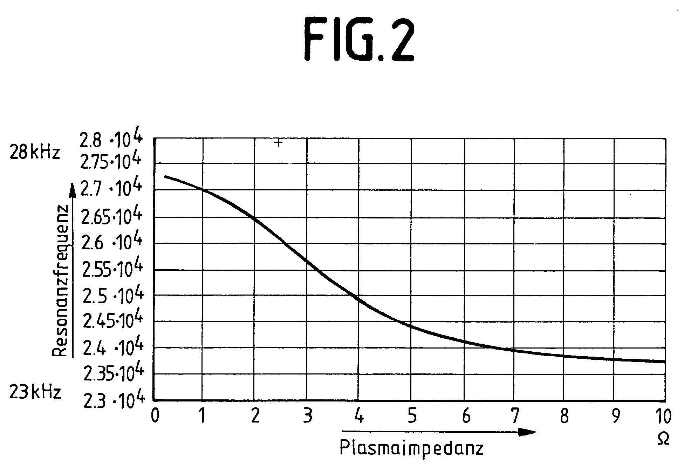

In der Fig. 2 ist die Kennlinie dargestellt, die den Zusammenhang zwischen der Plasmaimpedanz und der Frequenz zeigt. Man erkennt hieraus, dass der Plasmawiderstand bei einer Resonanzfrequenz von 2.75 · 10⁴ Hz relativ niedrig und bei einer Resonanzfrequenz von 2.3 · 10⁴ Hz relativ hoch ist. Um die Resonanzfrequenz etwa bei 2.5 · 10⁴ Hz konstant zu halten, muss die Plasmaimpedanz auf etwa 4 Ω gehalten werden. Verändert sich die Plasmaimpedanz, so wird durch die Regelung des Gaszuflusses die Plasmaimpedanz wieder auf ihren alten Wert gebracht.

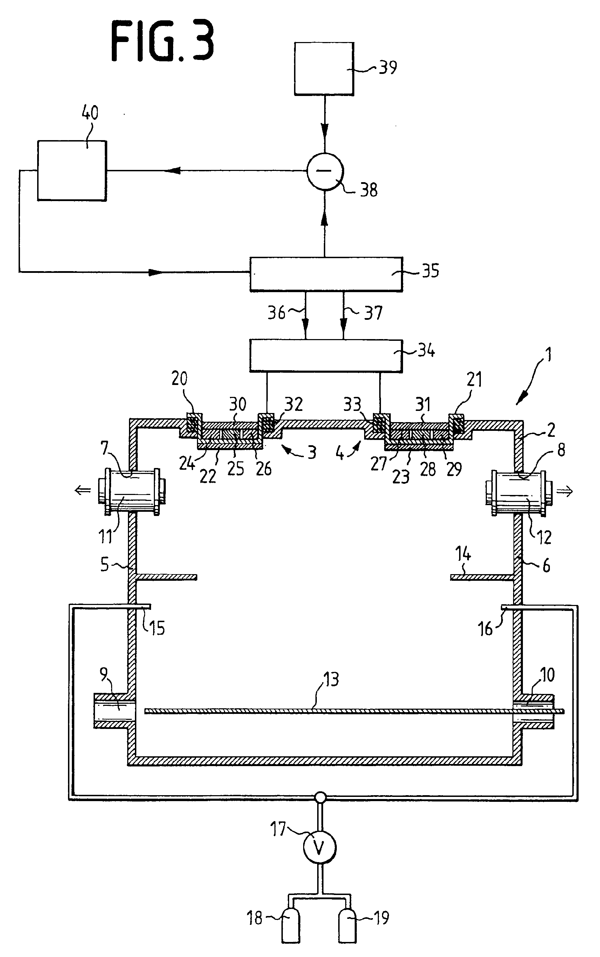

Die Fig. 3 zeigt eine Ausführungsform der Erfindung, bei welcher nicht der Zufluss des Prozess- oder Reaktivgases geregelt wird, sondern die elektrische Leistung des Mittelfrequenzgenerators. Die Plasmaimpedanz ist nämlich nicht nur von dem Gaszufluss abhängig, sondern auch noch von anderen Größen wie Strom, Spannung und Leistung, einem das Plasma durchsetzenden Magnetfeld, einer das Plasma bestrahlenden UV-Strahlung, der Gaszusammensetzung oder der Anreicherung der Targetoberfläche mit Reaktivgasanteilen.

Das Prinzip der Regelung gemäß dem Ausführungsbeispiel nach Fig. 3 ist das gleiche wie bei dem Ausführungsbeispiel nach Fig. 1. Weicht die Resonanzfrequenz von ihrem Sollwert ab, wird die den Magnetrons 3, 4 zugeführte elektrische Leistung solange vergrößert oder verkleinert, bis sich der Sollwert der Resonanzfrequenz eingestellt hat.

Bei den vorstehend beschriebenen Ausführungsbeispielen wurde jeweils eine Prozessvariable - der Gaszufluss bzw. die elektrische Leistung - geregelt. Es ist jedoch auch möglich, mehrere Prozessvariablen kombiniert zu regeln. Wesentlich ist nur, dass die Regelvorgänge die Ist-Frequenz des freischwingenden Mittelfrequenzgenerators auf die Soll-Frequenz bringen.

Statt zweier Kathoden, wie in den Fig. 1 und 3 dargestellt, kann die Erfindung auch mit nur einer Kathode realisiert werden. Die Plasmastrecke bildet sich dann nicht zwischen den beiden Kathoden, sondern zwischen der Kathode und einer Anode aus. Die Anode kann hierbei durch die Vakuumkammer 2 oder durch eine in der Vakuumkammer 2 aufgehängte isolierte Elektrode gebildet werden. Der einzustellende Arbeitspunkt hängt von den Anforderungen ab, die an die Schicht gestellt werden, die sich auf dem Substrat 13 niederschlägt.

## Patentansprüche

1. Einrichtung für die Regelung einer Plasmaimpedanz, mit einer Vakuumkammer, in der sich wenigstens eine Elektrode befindet, die mit einem Wechselstromgenerator in Verbindung steht, wobei in die Vakuumkammer ein Prozessgas einführbar ist, **gekennzeichnet durch**
- einen freischwingenden Wechselstromgenerator (35), dessen Frequenz sich auf die Resonanzfrequenz der mit ihm verbundenen Beschaltung einstellt;
- einen Frequenz-Sollwertgeber (39);
- eine Einrichtung (40), die in Abhängigkeit von der Differenz zwischen Frequenz-Soll- und Frequenz-Istwert einen Parameter regelt, der die Plasmaimpedanz beeinflusst.

2. Einrichtung nach Anspruch 1, **dadurch gekennzeichnet, dass** in die Vakuumkammer (2) ein Prozessgas einfüllbar ist.

3. Einrichtung nach Anspruch 1, **dadurch gekennzeichnet, dass** der Wechselstromgenerator eine Wechselrichterbrücke mit Steuerelektronik enthält.

4. Einrichtung nach Anspruch 1, **dadurch gekennzeichnet, dass** die Elektrode eine Kathode ist.

5. Einrichtung nach Anspruch 1, **dadurch gekennzeichnet, dass** sie bei reaktiven Sputterprozessen eingesetzt wird.

6. Einrichtung nach Anspruch 1, **dadurch gekennzeichnet, dass** ein Differenzbildner (38) vorgesehen ist, der die Differenz zwischen Soll- und Istfrequenz ermittelt.

7. Einrichtung nach Anspruch 1, **dadurch gekennzeichnet, dass** der geregelte Parameter die Prozessgaszufuhr ist.

8. Einrichtung nach Anspruch 1, **dadurch gekennzeichnet, dass** der geregelte Parameter die Reaktivgaszufuhr ist.

9. Einrichtung nach Anspruch 1, **dadurch gekennzeichnet, dass** der geregelte Parameter die vom Wechselstromgenerator (35) an die Kathode abgegebene elektrische Leistung ist.
